# EUROPEAN PATENT APPLICATION

(11) **EP 0 936 667 A1**
(43) Date of publication of application: **18.08.1999**
(21) Application number: 99300212.0
(22) Date of filing: 12.01.1999
(51) Int. Cl.: H01L 21/8238, H01L 21/225, H01L 21/28

(54) **Lattice matched barrier for dual doped polysilicon gates**

(30) Priority: 20.01.1998 US 9605
(71) Applicant: LUCENT TECHNOLOGIES INC., Murray Hill, New Jersey 07974-0636 (US)
(72) Inventor: Kizilyalli, Isik C, Orlando, Florida 32819 (US); Merchant, Sailesh Mansinh, Orlando, Florida 32835 (US); Roy, Pradip Kumar, Orlando, Florida 32819 (US); Vaidya, Hem M., Orlando, Florida 32835 (US)
(74) Representative: Watts, Christopher Malcolm Kelway, Dr.

(57) **Abstract**

The present invention generally provides a layered stack that can be used in a metal oxide semiconductor. In certain embodiments, the layered stack may be a gate stack that can be used in semiconductor devices, such as a complementary metal oxide semiconductor (CMOS) devices. In another embodiment, the layered stack comprises a dual doped layer having a first doped region and a second doped region in contact with each other, a barrier layer located on the dual doped layer and overlapping the first and second doped regions. The barrier layer includes a nitrided metal silicide. This particular embodiment further includes an ancillary conductive layer located on the barrier layer and that includes an ancillary conductive layer metal silicide.

## Description

### Technical Field of the Invention

The present invention is directed, in general, to Metal Oxide Semiconductors (MOS) and, more specifically, to Complementary Metal Oxide Semiconductors (CMOS) having dual doped polysilicon gates.

### Background of the Invention

As feature sizes of Very-Large-Scale-Integrated (VLSI) circuits are reduced, there is also a corresponding trend to operate these circuits at low power dissipation and at faster speeds. Hence, semiconductor devices are required to operate at lower voltages. One particular semiconductor device that can operate at lower voltages is a dual doped polysilicon gate complementary metal oxide semiconductor (CMOS) device.

Such dual doped polysilicon gate CMOS devices have a p⁺ polysilicon gate for a PMOS device and an n⁺ polysilicon gate for the NMOS device. The presence of the p⁺ polysilicon gate for the PMOS device facilitates the reduction of the threshold voltages of the PMOS devices, permitting lower voltage operation and allowing gate length reduction. The presence of the p⁺ polysilicon gate contacting the n⁺ polysilicon gate, however, introduces the problem of lateral doping or inter diffusion. The dopants diffuse and eventually, the PMOS device will counter-dope the NMOS device and vice-versa. Furthermore, if the polysilicon gates also include a metal film to reduce the contact resistance of the gate (which is typically the case), such as tungsten silicide, the inter diffusion problem is exacerbated. The dopant (both n⁺, such as arsenic and phosphorous and p⁺, such as boron) diffusion rates through the tungsten silicide layer is significantly greater than their diffusion rates through the polysilicon, possibly 10 to a 100 times faster. A polysilicon/metal layer gate configuration is hereafter referred to as a gate stack or polycide gate stack.

To minimize the diffusion of the dopants through the metal film, a barrier layer may be placed between the polysilicon gates and the metal film. In a conventional barrier layer, the material typically used is titanium-nitride (TiN) or tungsten nitride with the corresponding materials used in the metal layer being tungsten silicide. The titanium-nitride, however, oxidizes at typical integrated circuit processing temperatures making it prone to oxidation problems. Furthermore, titanium-nitride cannot withstand the high temperatures of certain subsequent processing steps, such as annealing. With regard to the tungsten nitride for the barrier layer, there is poor lattice matching between the tungsten nitride and the tungsten silicide, which causes an increase in the stack resistance and results in structural imperfections. The resistance of the gate stack has a direct relationship to the lattice parameters of the materials used in the gate stack. The better the match between the lattice parameters of the materials, the lower the resistance of the gate stack and vice-versa. Therefore, the differences between the lattice parameters of tungsten silicide and the barrier layer prevent the minimizing of the contact resistance of the gate stack.

Accordingly, what is needed in the art is an improved dual doped polycided gate and a method of manufacture thereof.

### Summary of the Invention

To address the above-discussed deficiencies of the prior art, the present invention generally provides a layered stack that can be used in a metal oxide semiconductor. In certain embodiments, the layered stack may be a gate stack that can be used in semiconductor devices, such as a complementary metal oxide semiconductor (CMOS) devices. In another embodiment, the layered stack comprises a dual doped layer having a first doped region and a second doped region in contact with each other, a barrier layer located on the dual doped layer and overlapping the first and second doped regions. The barrier layer includes a nitrided metal silicide. This particular embodiment further includes an ancillary conductive layer located on the barrier layer and that includes an ancillary conductive layer metal silicide.

In one embodiment of the present invention the dual doped layer comprises polysilicon that has a p-type doped region in contact with a n-type doped region. In certain embodiments, the p-type doped region includes boron and the n-type doped region includes arsenic or phosphorous. However, in other embodiments, the nitrided metal silicide may be selected from the group consisting of molybdenum-silicon-nitride, tantalum-silicon-nitride, nickel-silicon-nitride, niobium-silicon-nitride or titantium-silicon-nitride. In yet another embodiment, the nitrided metal silicide is tungsten-silicon-nitride.

In a particular embodiment, the ancillary conductive layer metal silicide may be tungsten silicide, which in an advantageous embodiment is substantially non-nitrided, i.e., the amount of nitrogen present is such that is does not effectively act as a barrier against the diffusion of a dopant, such as boron. In another embodiment, however, the barrier layer is comprises tungsten-silicon-nitride, and the ancillary conductive layer metal silicide comprises tungsten silicide.

The silicide compositions of the barrier layer and the ancillary conductive layer, in certain embodiments, may be lattice matched. The lattice matching provides certain advantages not found in prior art stack combinations. For instance, it is believed that lattice matching provides decreased resistance of the polycide gate stack. Additionally, structural imperfections may be decreased as the result of lattice matching and thereby increase the overall reliability of the semiconductor device.

In yet another embodiment, the ancillary conductive layer metal silicide may be selected from the group consisting of molybdenum silicide, tantalum silicide, nickel silicide, niobium silicide or titantium silicide.

The foregoing has outlined, rather broadly, preferred and alternative features of the present invention so that those skilled in the art may better understand the detailed description of the invention that follows. Additional features of the invention will be described hereinafter that form the subject of the claims of the invention. Those skilled in the art should appreciate that they can readily use the disclosed conception and specific embodiment as a basis for designing or modifying other structures for carrying out the same purposes of the present invention.

### Brief Description of the Drawings

For a more complete understanding of the present invention, reference is now made to the following descriptions taken in conjunction with the accompanying drawings, in which:
FIGURE 1A illustrates an exemplary schematic representation of a complementary metal oxide semiconductor (CMOS);
FIGURE 1B illustrates an isometric view of an exemplary polycided gate with dual doped regions;
FIGURE 2 illustrates an exemplary schematic cross-sectional view of a typical complementary metal oxide semiconductor (CMOS) device with a dual doped polycide gate stack;
FIGURE 3 illustrates a schematic cross-sectional view of an embodiment of a complementary metal oxide semiconductor (CMOS) device with a dual doped polycide gate stack constructed according to the principles of the present invention; and
FIGURE 4 illustrates an exemplary isothermal section of a tungsten-silicon-nitride system at 1000°C.

### Detailed Description

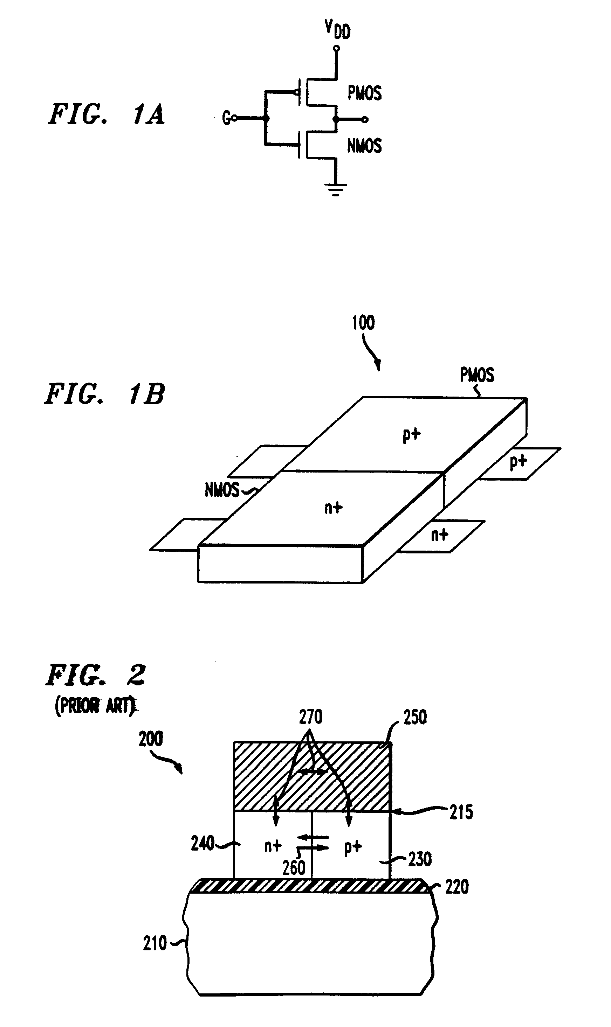

Referring initially to FIGUREs 1A and 1B, FIGURE 1A illustrates an exemplary schematic representation of a complementary metal oxide semiconductor (CMOS). The dual gate CMOS illustrated in FIGURE 1A is one example of a semiconductor device that operates at lower voltages. Currently, to form the PMOS and NMOS devices, a single doped polysilicon gate is used and the dopant will also typically be n-type. The resulting PMOS device will have a high threshold voltage, typically, not less than 0.7 volts, which does not meet the current need for lower voltage operational devices. To lower the threshold voltage of the PMOS device, a p-type polysilicon gate is required.

Turning now to FIGURE 1B, illustrated is an isometric view of an exemplary polycided gate 100 with dual doped regions. The dual doped gate 100 includes two regions comprised of an n-type polysilicon and a p-type polysilicon. As illustrated in this exemplary embodiment, the n-type polysilicon region and the p-type polysilicon regions adjoin one another. As previously discussed, while some dopant interdiffusion occurs in these devices by way of the interface at which the two regions join, the diffusion rate is acceptable. However, when a metal layer is formed over these two regions, the dopant interdiffusion rate is substantially increased, which with subsequent processing alters the desired device characteristics. Turning now to FIGURE 2, illustrated is an exemplary schematic cross-sectional view of a conventional complementary metal oxide semiconductor (CMOS) device 200 with a dual doped polycide gate stack 215. The semiconductor 200 includes a substrate 210, which may be formed from materials such as silicon, germanium, gallium arsenide or other materials known to those skilled in the art. The gate stack 215 is shown positioned over a gate dielectric 220 which is also formed by conventional processes over the substrate 210.

The gate stack 215 generally includes a dual doped polysilicon layer that comprises a p-type doped region 230, as part of a PMOS structure, and a n-type doped region 240, as part of a NMOS structure. In most conventional devices of this type, a metal layer 250 is formed over the p-type and n-type regions 230, 240 using conventional processes, such as physical vapor deposition. The metal layer 250 is used to lower the contact resistance of the gate stack 215.

As discussed above, with the p-type and n-type polysilicon regions 230, 240 situated next to each other, lateral doping or cross doping is introduced. The dopants, within n-type and p-type polysilicon, diffuse laterally in the direction of the diffusion path (generally designated as 260). A more severe cross doping occurs, however, through the metal layer 250 as depicted by the diffusion path (generally designated as 270). The p⁺ region 230 will counter-dope the n⁺ region 240 and vice-versa, resulting in cross-contamination of the PMOS and NMOS devices. The use of the metal layer 250 to reduce the resistance of the gate 215 exacerbates the diffusion problem. The rate of diffusion through the metal layer 250, depicted by the direction arrows 270, is typically 10 to 100 times larger, depending on the material used in the metal layer 250, than the lateral rate of diffusion indicated by the direction arrows 260.

One approach to eliminate or substantially reduce this cross diffusion has been to introduce a barrier layer between the n-type and p-type regions 230, 240 and the metal layer 250. The barrier layer is used to retard or substantially reduce the diffusion through the diffusion path 270, which is the primary contributor to the cross-doping problem. To minimize the diffusion of the dopants through the metal film, a barrier layer is typically placed between the polysilicon regions and the metal film. In a conventional barrier layer, the material typically used is titanium-nitride or tungsten silicide with the corresponding materials used in the metal layer being tungsten nitride. The titanium-nitride, however, oxidizes at typical integrated circuit processing temperatures making it prone to oxidation problems. Furthermore, titanium-nitride cannot withstand the high temperatures of certain subsequent processing steps, such as annealing. With regard to the tungsten nitride functioning as the barrier, there is poor lattice matching between the tungsten-nitride and the tungsten silicide metal layer, which can cause an increase in the stack resistance and result in structural imperfections. The better the match between the lattice parameters of the materials, the better structural, mechanical and metallurgical continuity across the interface, which results in a device that has an overall improved structural integrity. Therefore, the differences between the lattice parameters of tungsten-silicon-nitride and tungsten silicide prevents the minimizing of the contact resistance of the gate stack.

The present invention addresses the above-discussed problems with the prior art and provides a dual doped structure wherein the barrier and metal layers of a gate stack are epitaxial or quasi-epitaxial matched. It is believed that this matching produces a matched lattice across the interface between the barrier layer and the metal layer such that it is no longer a "real" interface but becomes a "virtual" interface, which significantly improves the strucutal integrity of the device.

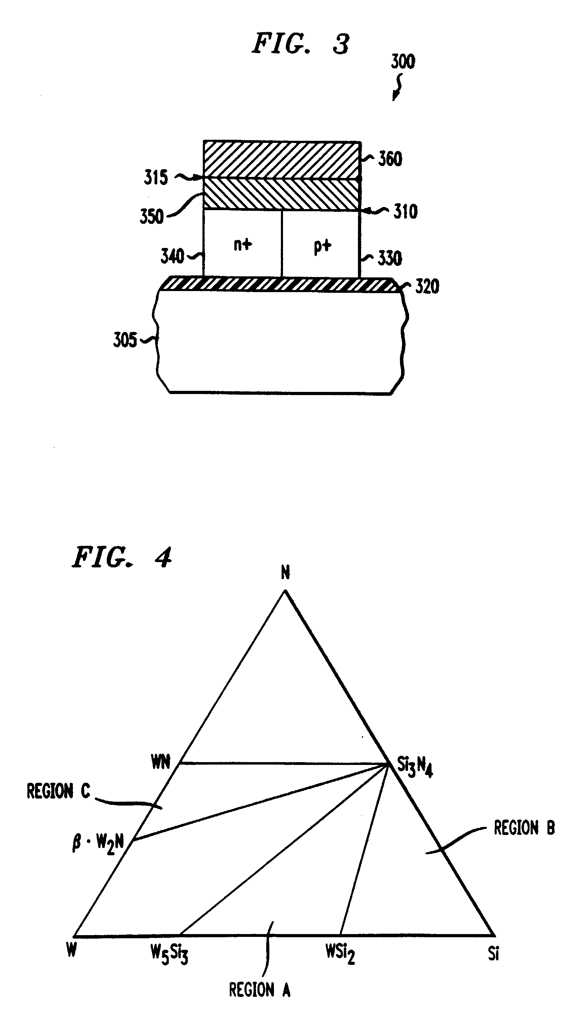

Turning now to FIGURE 3, illustrated is a schematic cross-sectional view of an embodiment of a complementary metal oxide semiconductor (CMOS) device 300 with a dual doped gate stack 315 constructed according to the principles of the present invention. The semiconductor 300 includes a substrate 305, which may be formed from materials such as silicon, germanium, germanium arsenide or other materials known to those skilled in the art, and a polysilicon gate layer 310. A gate dielectric, layer 320, is formed over the substrate 305 using conventional processes well known in the art. Located on top of the gate dielectric layer 320 is the dual doped polysilicon gate layer 310, comprising an n-type region 340 and a p-type region 330. This polysilicon gate layer 310, is also deposited using conventional processes. In an advantageous embodiment, the p-type region 330 includes boron and the n-type region includes arsenic or phosphorus.

Following the formation of the polysilicon gate layer 310, a barrier layer 350, which includes nitrided metal silicide, is formed using conventional processes, such as physical (sputtering) or chemical vapor deposition. In an advantageous embodiment, the barrier layer is formed using a sputtering process at 3 to 6 mtorr pressure at 100°C to 400°C, using an argon and nitrogen mixture with the nitrided metal silicide being tungsten-silicon-nitride. In another embodiment, the nitrided metal silicide may be selected from a group consisting of molybdenum-silicon-nitride, tantalum-silicon-nitride, nickel-silicon-nitride, niobium-silicon-nitride or titantium-silicon-nitride.

One particular embodiment of the present invention describes the use of ternary barrier materials, such as tungsten-silicon-nitride, with lattice matched structures to the polysilicon or metal silicide used for the gate stack. The composition of such ternary barriers must be such that their lattice parameters and thermal decomposition properties must be close to that of the metal silicide or polysilicon for obtaining lattice matched structures. In an advantageous embodiment of the present invention, the nitrogen is "dissolved" or used in such a manner so as to "stuff" the grain boundaries of the binary metal silicide material. Reference to the tungsten-silicon-nitride isothermal section of the tungsten-silicon-nitride phase diagram illustrated in FIGURE 4 is necessary in order to understand the implications of a ternary tungsten-silicon-nitride diffusion barrier layer.

Turning now to FIGURE 4, illustrated is an exemplary isothermal section of a tungsten-silicon-nitrogen system at 1000°C. This phase diagram is adapted from "Phase Diagrams of Ternary Boron Nitride and Silicon Nitride Systems," edited by P. Rogl and J.C. Schuster, ASM International, Materials Park, OH, 1992, p. 208.

Although binary tungsten nitride (WN) does not exist at 1000°C without a nitrogen (N₂) ambient, the tie-line connecting silicon nitride (Si₃N₄) and WN is depicted for the sake of completeness.

When using a ternary barrier on polysilicon, it is appropriate to fabricate compositions of the barrier within the three-phase region or tie-triangle Si-WSi₂-Si₃N₄, marked region B, or tie-triangle Si₃N₄-WSi₂-W₅Si₃, marked region A. If there is any decomposition of the ternary barrier, such as during a subsequent thermal anneal, the barrier breakdown results in the formation of WSi₂ and Si for region B or WSi₂ and W₅Si₃ for region A, respectively. Both the silicides (WSi₂ and W₅Si₃) and Si will precipitate epitaxially onto the existing tungsten silicide or polysilicon causing a desired lattice matched structure. If a composition such as the one located in region C is chosen, the decomposition of the ternary barrier will result in the formation of WN, W₂N and Si₃N₄, all phases that have significant differences in lattice parameters with both polysilicon and WSi₂. Also, the prior art usage of WN as a barrier material is not adequate because of a lack of a tie-line between WN and WSi₂. In the event that WN sees a thermal excursion after it has been deposited, especially in the absence of N₂, it will decompose to intermediate products such as W and W₂N, phases with poor lattice parameter matching with both tungsten silicide and the poysilicon, depending on its composition and location on the ternary isothermal section.

A consequence of matching lattice structures, as described above, is to decreases the resistance of the gate stack. Additionally, structural imperfections are also reduced as a result of the lattice matching, which in turn, increases the overall reliability of the semiconductor device.

Referring again to FIGURE 3, after the formation of the barrier layer 350, an ancillary conductive or metal layer 360 is deposited using conventional processes. The selection of materials for the barrier layer 350 and metal layer 360 may vary. For example, in one embodiment, the barrier layer 350 may be a nitrided tungsten silicide and the metal layer 360 may comprise tungsten silicide that is substantially non-nitrided, i.e., the amount of nitrogen present is such that it does not act effectively as a barrier against the diffusion of a dopant, such as boron. In other embodiments, the metal silicide used in the barrier layer 350 may be molybdenum silicide, tantalum silicide, nickel silicide, niobium silicide or titantium silicide. Likewise the metal layer 360 may also be selected from this group. While the metal layer 360 may be non-nitrided, it should be understood that nitrogen may be present in this layer as well.

Another advantage for using a metal silicide and a nitrided metal silicide combination is in the deposition processes. For example, tungsten silicide and tungsten-silicon-nitride materials may be deposited in the same deposition chamber, an advantage over the prior art, by controlling the introduction of the nitrogen gas into the deposition chamber. The presence of the nitrogen in the chamber forms the nitride, conversely, the absence of the nitrogen forms the silicide.

Following the formation of the gate stack 315, completion of the dual gate semiconductor device 300 is accomplished using conventional processes well known in the art.

From the foregoing it is apparent that the present invention provides a layered stack that can be used in a metal oxide semiconductor. The layered stack may be a gate stack that can be used in semiconductor devices, such as CMOS devices. In another embodiment, the layered stack comprises a dual doped layer having a first doped region and a second doped region in contact with each other, a barrier layer located on the dual doped layer and overlapping the first and second doped regions. The barrier layer includes a nitrided metal silicide. This particular embodiment further includes an ancillary conductive layer located on the barrier layer and that includes an ancillary conductive layer metal silicide.

## Claims

1. For use in a metal oxide semiconductor, a layered stack, comprising:
a dual doped layer having a first doped region and a second doped region in contact with each other;
a barrier layer located on said dual doped layer and overlapping said first and second doped regions, said barrier layer including a nitrided metal silicide; and
an ancillary conductive layer located on said barrier layer, said ancillary conductive layer including an ancillary conductive layer metal silicide.

2. The layered stack as recited in Claim 1 wherein said dual doped layer comprises polysilicon having a p-type doped region in contact with a n-type doped region.

3. The layered stack as recited in Claim 2 wherein said p-type doped region includes boron and said n-type doped region includes arsenic or phosphorus.

4. The layered stack as recited in Claim 1 wherein said nitrided metal silicide is selected from the group consisting of:
molybdenum-silicon-nitride
tantalum-silicon-nitride;
nickel-silicon-nitride;
niobium-silicon-nitride; and
titantium-silicon-nitride.

5. The layered stack as recited in Claim 1 wherein said nitrided metal silicide is tungsten-silicon-nitride.

6. The layered stack as recited in Claim 1 wherein said ancillary conductive layer metal silicide is tungsten silicide.

7. The layered stack as recited in Claim 1 wherein said ancillary conductive layer metal silicide is selected from the group consisting of:
molybdenum silicide
tantalum silicide;
nickel silicide;
niobium silicide; and
titantium silicide.

8. A method of fabricating a layered stacked in a metal oxide semiconductor, comprising the steps of:
forming a dual doped layer having a first doped region and a second doped region such that said first doped region and said second doped region are in contact with each other;
forming a barrier layer on said dual doped layer that overlaps said first and second doped regions and incorporating a nitrided metal silicide in said barrier layer; and
forming an ancillary conductive layer located on said barrier layer, said ancillary conductive layer including an ancillary conductive layer metal silicide.

9. The method as recited in Claim 8 wherein said step of forming a dual doped layer includes the step of forming a p-type doped region and a n-type doped region in a polysilicon substrate.

10. The method as recited in Claim 9 wherein said step of forming a p-type doped region includes diffusing boron in said polysilicon substrate and forming said n-type doped region includes diffusing arsenic or phosphorus in said polysilicon substrate.

11. The method as recited in Claim 8 wherein said step of incorporating includes the step of selecting said nitrided metal silicide from the group consisting of:
molybdenum-silicon-nitride
tantalum-silicon-nitride;
nickel-silicon-nitride;
nyobium-silicon-nitride; and
titantium-silicon-nitride.

12. The method as recited in Claim 8 wherein said step of incorporating includes the step of incorporating tungsten-silicon-nitride in said barrier layer.

13. The method as recited in Claim 8 wherein said step of forming an ancillary conductive layer includes the step of incorporating tungsten silicide in said ancillary conductive layer.

14. The method as recited in Claim 8 wherein said step of forming an ancillary conductive layer includes selecting said metal silicide from the group consisting of:
molybdenum silicide
tantalum silicide;
nickel silicide;
nyobium silicide; and
titantium silicide.

15. A complementary metal oxide semiconductor device having a stacked gate comprising a layered stack as claimed in any of claims 1 to 7.
